Europäisches Patentamt

European Patent Office

Office européen des brevets

(19)

(11) EP 0 903 926 A1

(12) **EUROPÄISCHE PATENTANMELDUNG**

(43) Veröffentlichungstag:
24.03.1999 Patentblatt 1999/12

(51) Int Cl.6: **H04M 19/04**, H04M 19/02,
H02M 7/48

(21) Anmeldenummer: 98440182.8

(22) Anmeldetag: 21.08.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 12.09.1997 DE 19740137

(71) Anmelder: ALCATEL
75088 Paris (FR)

(72) Erfinder:
• Manicke, Ulrich
  15370 Vogelsdorf (DE)
• Stiawa, Ralf
  12619 Berlin (DE)

(74) Vertreter: Müller, Joachim, Dipl.-Ing. et al
Alcatel Alsthom
Intellectual Property Department,
Postfach 30 09 29
70449 Stuttgart (DE)

(54) **Verfahren und Schaltungsanordnung zur Rufwechselspannungserzeugung für elektronische Teilnehmerschaltungen**

(57) Um die Wärmeentwicklung von in großer Anzahl in Telekommunikationsanlagen vorhandener Teilnehmeranschlußschaltungen zu begrenzen, muß die Verlustleistung dieser Schaltungen möglichst gering gehalten werden. Mit der Erfindung wird erreicht, daß die Verlustleistung des Leistungsverstärkers (1), der eine Rufwechselspannung geringer Amplitude verstärkt, dadurch verringert wird, daß die Betriebsspannung ($U_{Bi}$) des Leistungsverstärkers (1) nicht wie bekannt konstant ist, sondern geregelt wird. Das erfolgt über einen einfachen Schaltregler (2), so daß die Betriebsspannung ($U_{Bi}$) in großen Zeitabschnitten nur unwesentlich größer als die Rufwechselspannung ($U_{RA}$) ist.

Fig.1

**Beschreibung**

Die Erfindung betrifft ein Verfahren und eine Schaltungsanordnung zur Rufwechselspannungserzeugung für elektronische Teilnehmerschaltungen und dient dazu, in einem Fernsprechendgerät einen ankommenden Ruf zu signalisieren.

Es ist allgemein bekannt, für die Rufwechselspannungserzeugung Spannungswandler einzusetzen, die von der in der Fernsprechvermittlungstechnik üblichen negativen Batteriespannung gespeist werden und eine sinusförmige Wechselspannung ausreichend hoher Amplitude erzeugen.

In der europäischen Patentschrift EP-B1-0 499 869 wird eine Schaltungsanordnung zur Erzeugung einer Wechselspannung beschrieben, die mit Hilfe eines Transformators und zweier Schaltstufen realisiert wird. Mit der ersten Schaltstufe T1 wird eine positive Ausgangsspannung erzeugt, nämlich der ansteigende Bereich der Rufwechselspannung. Eine zweite Schaltstufe T2 dient zur Realisierung eines niederohmigen Ausgangs der Schaltungsanordnung zur Entladung des an den Ausgang angeschlossenen komplexen Lastwiderstandes ZL, der als RC-Glied einen elektroakustischen Wandler repräsentiert. In einer ersten Arbeitsphase ist die erste Schaltstufe T1 aktiv, die Ausgangsspannung steigt an und das angeschlossene RC-Glied wird aufgeladen. In einer zweiten sich anschließenden Arbeitsphase ist die zweite Schaltstufe T2 aktiv, die Ausgangsspannung nimmt ab und das angeschlossene RC-Glied wird entladen, die Stromrichtung kehrt sich um. Eine derartige Schaltungsanordnung ist kostenaufwendig, da einerseits der Transformator ein teures Bauelement ist und andererseits der schaltungstechnische Aufwand groß ist, um die Forderung nach einem geringen Innenwiderstand des Rufwechselspannungsgenerators für beide Stromrichtungen erfüllen zu können, damit die in den elektroakustischen Wandlern enthaltenen Kondensatoren genügend schnell umgeladen werden können.

Mit der Erfindung wird nun die Aufgabe gelöst, ein Verfahren und eine Schaltungsanordnung zur Rufwechselspannungserzeugung anzugeben, die ohne Transformator mit geringem Bauelementeaufwand kostengünstig realisierbar sind, wobei die Schaltungsanordnung einen kleinen Innenwiderstand hat.

Diese Aufgabe wird durch das im ersten Patentanspruch beschriebene Verfahren und die im dritten Patentanspruch beschriebene Schaltungsanordnung gelöst.

Das Wesen der Erfindung besteht darin, daß mit Hilfe eines einfachen Gleichspannungswandlers die Versorgungsspannung eines Leistungsverstärkers, der von einer Rufwechselspannung geringer Amplitude angesteuert wird, so geregelt wird, daß die Versorgungsspannung nur unwesentlich größer als die erforderliche Rufwechselspannung ist, so daß die Rufwechselspannungserzeugung mit hohem Wirkungsgrad ermöglicht wird.

Die Erfindung wird nunmehr an einem Ausführungsbeispiel erläutert. In der dazugehörigen Zeichnung zeigt

Fig. 1 ein Schaltbild der erfindungsgemäßen Schaltungsanordnung und
Fig. 2 ein Zeitdiagramm für den Verlauf der Versorgungsspannung $U_{Bi}$ und der Ausgangsspannung $U_{RA}$ des Leistungsverstärkers 1

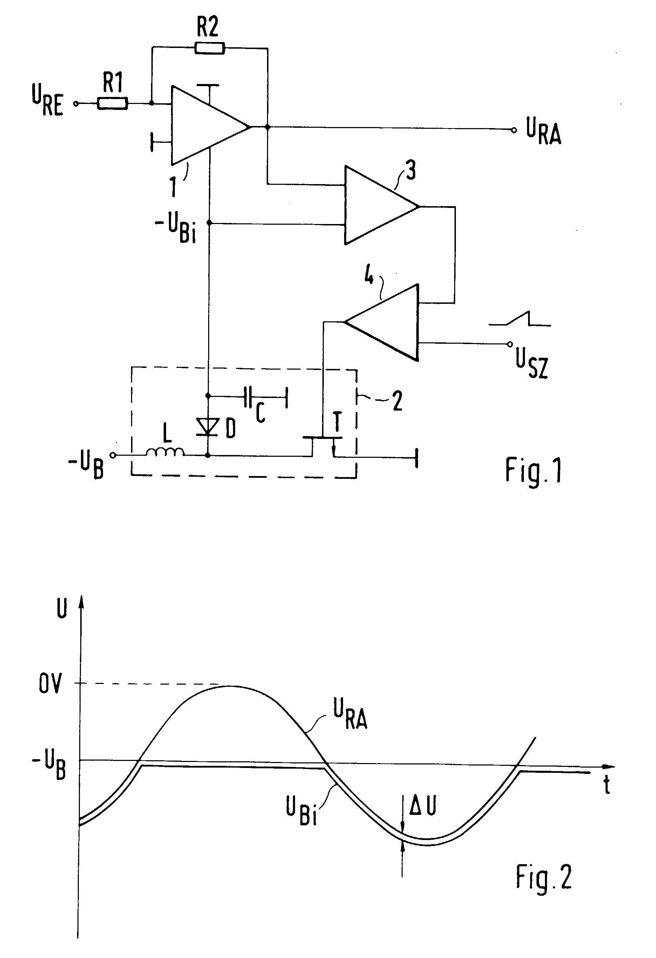

Gemäß Fig. 1 besteht die erfindungsgemäße Schaltungsanordnung im wesentlichen aus einem Leistungsverstärker 1, einem Schaltregler 2, einem ersten Komparator 3 und einem zweiten Komparator 4. Der Schaltregler 2 besteht in bekannter Weise aus einem Schalttransistor T, einer Diode D, einem Ladekondensator C sowie einer Drosselspule L.

Der Leistungsverstärker 1 wird über einen Widerstand R1 von einer Rufwechselspannung $U_{RE}$ geringer Amplitude angesteuert. Durch das Verhältnis der Widerstände $\frac{R2}{R1}$ wird der Verstärkungsfaktor des Leistungsverstärkers 1 bestimmt. Der Ausgang des Leistungsverstärkers 1 ist mit einem ersten Eingang des ersten Komparators 3 verbunden, dessen zweiter Eingang an den Betriebsspannungsanschluß des Leistungsverstärkers 1 geschaltet ist. Mit dem ersten Komparator 3 wird die Ausgangsspannung $U_{RA}$ des Leistungsverstärkers 1, das ist die geforderte Rufwechselspannung $U_{RA}$, mit der Betriebsspannung $U_{Bi}$ des Leistungsverstärkers 1 verglichen. Mit dem Ausgangssignal des ersten Komparators 3 wird der zweite Komparator 4 angesteuert, an dessen zweitem Eingang eine sägezahnförmige Spannung $U_{SZ}$ liegt. Am Ausgang des zweiten Komparators 4 wird dadurch eine pulsbreitenmodulierte Spannung erzeugt, mit der der Schalttransistor T des Schaltreglers 2 angesteuert wird. Dieser Schalttransistor T bildet mit der Drosselspule L sowie mit der Diode D und dem Ladekondensator C einen Aufwärtswandler, mit dem in Abhängigkeit von der Pulsbreite, die Betriebsspannung $U_{Bi}$ des Leistungsverstärkers 1 im Vergleich zur Batteriespannung $U_B$ des Schaltreglers 2 vergrößert wird. Durch den Vergleich der Betriebsspannung $U_{Bi}$ mit der Rufwechselspannung $U_{RA}$ im ersten Komparator 3 wird erreicht, daß die Betriebsspannung $U_{Bi}$ des Leistungsverstärkers 1, sofern sie negativer als die Batteriespannung $U_B$ der Schaltreglers 2 ist, dem zeitlichen Verlauf der Rufwechselspannung $U_{RA}$ folgt, vgl. Fig. 2, so daß der Leistungsverstärker 1 eine wesentlich geringere Verlustleistung aufweist im Vergleich zu einem bisher üblichen Betrieb mit einer festen negativen Betriebsspannung.

In Fig. 2 ist die modulierte Betriebsspannung $U_{Bi}$ des Leistungsverstärkers 1 dargestellt. Die Spannungsdifferenz $\Delta U$ resultiert aus der endlichen internen Verstärkung des Regelkreises.

Der Leistungsverstärker 1 weist eine Endstufe auf, die für beide Stromrichtungen niederohmig ist, so daß an diese Rufwechselspannungsquelle angeschaltete Kondensatoren problemlos umgeladen werden können.

**Patentansprüche**

1. Verfahren zur Erzeugung einer Rufwechselspannung ($U_{RA}$) in einer elektronischen Teilnehmeranschlußschaltung mit einem Leistungsverstärker (1), **dadurch gekennzeichnet,** daß die Betriebsspannung ($U_{Bi}$) des Leistungsverstärkers (1) derart geregelt wird, daß die Betriebsspannung ($U_{Bi}$) in bestimmten zeitlichen Abschnitten dem zeitlichen Verlauf der Rufwechselspannung ($U_{RA}$) folgt.

2. Verfahren nach Anspruch 1, dadurch gekennzeichnet, daß die Rufwechselspannung ($U_{RA}$) mit der Betriebsspannung ($U_{Bi}$) des Leistungsverstärkers (1) verglichen wird und das Vergleichsergebnis pulsbreitenmoduliert einem Schaltregler (2) zugeführt wird, so daß für den Fall, daß der Betrag der Betriebsspannung ($U_{Bi}$) des Leistungsverstärkers (1) größer ist als der Betrag der Batteriespannung ($U_B$) des Schaltreglers (2), die Betriebsspannung ($U_{Bi}$) unmittelbar dem Verlauf der Rufwechselspannung ($U_{RA}$) folgt.

3. Schaltungsanordnung zur Durchführung des Verfahrens nach den Ansprüchen 1 und 2, dadurch gekennzeichnet, daß der Ausgang des Leistungsverstärkers (1) mit einem ersten Eingang eines ersten Komparators (3) verbunden ist, dessen zweiter Eingang an den Betriebsspannungsanschluß des Leistungsverstärkers (1) geschaltet ist, daß der Eingang des Leistungsverstärkers (1), der zugleich Eingang der Schaltungsanordnung ist, mit einer Rufwechselspannungsquelle geringer Leistung verbunden ist,
daß der Ausgang des ersten Komparators (3) mit einem ersten Eingang eines zweiten Komparators (4) verbunden ist, dessen zweiter Eingang in einer Sägezahnspannungsquelle liegt und
daß der Ausgang des zweiten Komparators (4) mit dem Eingang eines Schaltreglers (2) verbunden ist, dessen Ausgang an den Betriebsspannungsanschluß des Leistungsverstärkers (1) geschaltet ist.

Fig.1

Fig.2

Europäisches
Patentamt

## EUROPÄISCHER RECHERCHENBERICHT

Nummer der Anmeldung

EP 98 44 0182

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| D,A | EP 0 499 869 A (KOMMUNIKATIONS ELEKTRONIK) 26. August 1992 * Zusammenfassung; Abbildung 2 * --- | 1-3 | H04M19/04 H04M19/02 H02M7/48 |
| A | EP 0 083 529 A (NEUBAUER MICHEL) 13. Juli 1983 * Zusammenfassung; Abbildung 1 * --- | 1-3 | |
| A | EP 0 558 793 A (DEUTSCHE AEROSPACE) 8. September 1993 * das ganze Dokument * --- | 1-3 | |
| A | EP 0 483 094 A (ANDERSSON & BAEVHOLM LAB) 29. April 1992 * Zusammenfassung * ----- | 1-3 | |

RECHERCHIERTE SACHGEBIETE (Int.Cl.6)

H04M
H02M
H03F

Der vorliegende Recherchenbericht wurde für alle Patentansprüche erstellt

| Recherchenort | Abschlußdatum der Recherche | Prüfer |
|---|---|---|
| DEN HAAG | 25. Januar 1999 | Montalbano, F |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie,übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 98 44 0182

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-01-1999

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 0499869 | A | 26-08-1992 | DE | 4104809 | A | 20-08-1992 |
| | | | AT | 128287 | T | 15-10-1995 |
| | | | CN | 1064179 | A,B | 02-09-1992 |
| | | | DE | 59203709 | D | 26-10-1995 |
| | | | DK | 499869 | T | 06-11-1995 |
| | | | ES | 2078563 | T | 16-12-1995 |
| | | | GR | 3017830 | T | 31-01-1996 |
| EP 0083529 | A | 13-07-1983 | FR | 2519488 | A | 08-07-1983 |
| | | | FI | 824494 | A | 01-07-1983 |
| | | | JP | 58119210 | A | 15-07-1983 |
| EP 0558793 | A | 08-09-1993 | DE | 4206352 | A | 02-09-1993 |
| EP 0483094 | A | 29-04-1992 | SE | 467331 | B | 29-06-1992 |
| | | | DE | 69127340 | D | 25-09-1997 |
| | | | DE | 69127340 | T | 05-02-1998 |
| | | | SE | 9003426 | A | 27-04-1992 |
| | | | US | 5200711 | A | 06-04-1993 |

EPO FORM P0461

Für nähere Einzelheiten zu diesem Anhang : siehe Amtsblatt des Europäischen Patentamts, Nr.12/82